**Europäisches Patentamt**

**European Patent Office**

**Office européen des brevets**

(19)

(11) Veröffentlichungsnummer : **0 031 155**
**B1**

(12) **EUROPÄISCHE PATENTSCHRIFT**

(45) Veröffentlichungstag der Patentschrift :
**26.10.83**

(21) Anmeldenummer : **80108052.4**

(22) Anmeldetag : **19.12.80**

(51) Int. Cl.³ : **G 03 F 7/20**, G 02 B 27/17,
G 02 B 27/00

(54) **Anordnung zur punkt- und zeilenweisen Aufzeichnung von Bildinformationen.**

(30) Priorität : **22.12.79 DE 2952209**

(43) Veröffentlichungstag der Anmeldung :
**01.07.81 Patentblatt 81/26**

(45) Bekanntmachung des Hinweises auf die Patenterteilung : **26.10.83 Patentblatt 83/43**

(84) Benannte Vertragsstaaten :
**AT BE CH FR GB IT LI NL SE**

(56) Entgegenhaltungen :
**DE A 2 410 079**
**DE A 2 514 191**
**DE A 2 719 716**
**DE A 2 736 319**
**DE A 2 917 163**
**FR A 2 125 977**

(73) Patentinhaber : **DR.-ING. RUDOLF HELL GmbH**
**Grenzstrasse 1-5**
**D-2300 Kiel 14 (DE)**

(72) Erfinder : **Gebhardt, Axel**
**Strandweg 12**
**D-2301 Mönkeberg (DE)**
Erfinder : **Jürgensen, Heinrich**
**Dütschfeldredder 22**
**D-2301 Raisdorf (DE)**
Erfinder : **Roes, Christian**
**Starnberger Strasse 92**
**D-2300 Kiel 14 (DE)**

Jouve, 18, rue St-Denis, 75001 Paris, France

Anordnung zur punkt- und zeilenweisen Aufzeichnung von Bildinformationen

## Technisches Gebiet

Die Erfindung bezieht sich auf die elektronische Reproduktionstechnik, insbesondere auf die Aufzeichnung von Bildinformationen auf ein lichtempfindliches Aufzeichnungsmedium zur Herstellung von Druckflächen mittels eines aus einem Lichtleiter austretenden Strahlenbündels, welches durch eine Blende und ein Objektiv auf dem Aufzeichnungsmedium abgebildet wird.

## Zugrundeliegender Stand der Technik

In einem elektronischen Reproduktionsgerät wird eine Vorlage zur Gewinnung eines Bildsignals punkt- und zeilenweise optoelektronisch abgetastet. Ein optisches Aufzeichnungsorgan erzeugt einen Lichtstrahl, dessen Helligkeit durch das Bildsignal gesteuert wird. Der Lichtstrahl belichtet punkt- und zeilenweise ein lichtempfindliches Medium (Film), das beispielsweise auf einer rotierenden Aufzeichnungstrommel angeordnet ist.

Ein herkömmliches Aufzeichnungsorgan besteht z. B. aus einer ortsfesten, modulierbaren Laser-Lichtquelle, deren Licht in einen optischen Lichtleiter (Lichtfaser; optischer Wellenleiter) eingekoppelt wird, um es an den Aufzeichnungsort zu leiten. Das aus dem Lichtleiter austretende Licht leuchtet eine Blende aus, die mit Hilfe eines Objektivs als Belichtungspunkt auf das Aufzeichnungsmedium abgebildet wird. Zur zeilenweisen Belichtung wird der Lichtleiter einschließlich Blende und Objektiv axial an der Aufzeichnungstrommel entlangbewegt.

Üblicherweise findet in einem solchen optischen Aufzeichnungsorgan ein Multimode-Lichtleiter Verwendung, da es beieinem Monomode-Lichtleiter aufgrund seines sehr kleinen Kerndurchmessers äußerst schwierig ist, das von der Laser-Lichtquelle ausgehende Licht stabil in einen Monomode-Lichtleiter einzukoppeln.

Ein Multimode-Lichtleiter hat aber den Nachteil, daß die Lichtverteilung an seiner Austrittsfläche wegen der sich im Lichtleiter ausbildenden Moden ungleichförmig ist und sich zusätzlich noch bei einer mechanischen Bewegung des Lichtleiters ändert. Dadurch ist auch die Blende ungleichförmig ausgeleuchtet, und der Belichtungspunkt auf dem Aufzeichnungsmedium weist eine entsprechende inhomogene Lichtverteilung auf. Infolgedessen wird auch das Aufzeichnungsmedium streifig belichtet, was die Reproduktionsqualität erheblich beeinträchtigt. Ein weiterer Nachteil besteht darin, daß sich die Parameter wie Austrittsfläche und Austrittsapertur des Lichtleiters sehr schwer ohne Lichtverlust an die verschiedenen Blendendurchmesser und an die Apertur des Objektivs anpassen lassen.

## Offenbarung der Erfindung

Aufgabe der Erfindung ist es daher, ein optisches Aufzeichnungsorgan für elektronische Reproduktionsgeräte anzugeben, in dem die Blende zur Erzeugung einer streifenfreien Aufzeichnung stets homogen ausgeleuchtet wird und in dem nur geringe Lichtverluste entstehen.

Diese Aufgabe wird durch die im kennzeichnenden Teil des Anspruchs 1 angegebenen Merkmale gelöst. Eine andere Lösung wird im Anspruch 5, vorteilhafte Weiterbildungen in den Unteransprüchen angegeben.

## Kurze Beschreibung der Zeichnungen

Die Erfindung wird im folgenden anhand der Fig. 1-4 näher erläutert. Es zeigen:
Figur 1 ein Ausführungsbeispiel eines optischen Aufzeichungsorganes im Schnittbild;
Figur 2 ein weiters Ausführungsbeispiel eines optischen Aufzeichnungsorganes;
Figur 3a eine erste Einstellungsvariante;
Figur 3b eine zweite Einstellungsvariante;
Figur 4 ein anderes Ausführungsbeispiel für ein optisches Aufzeichnungsorgan.

## Bester Weg zur Ausführung der Erfindung

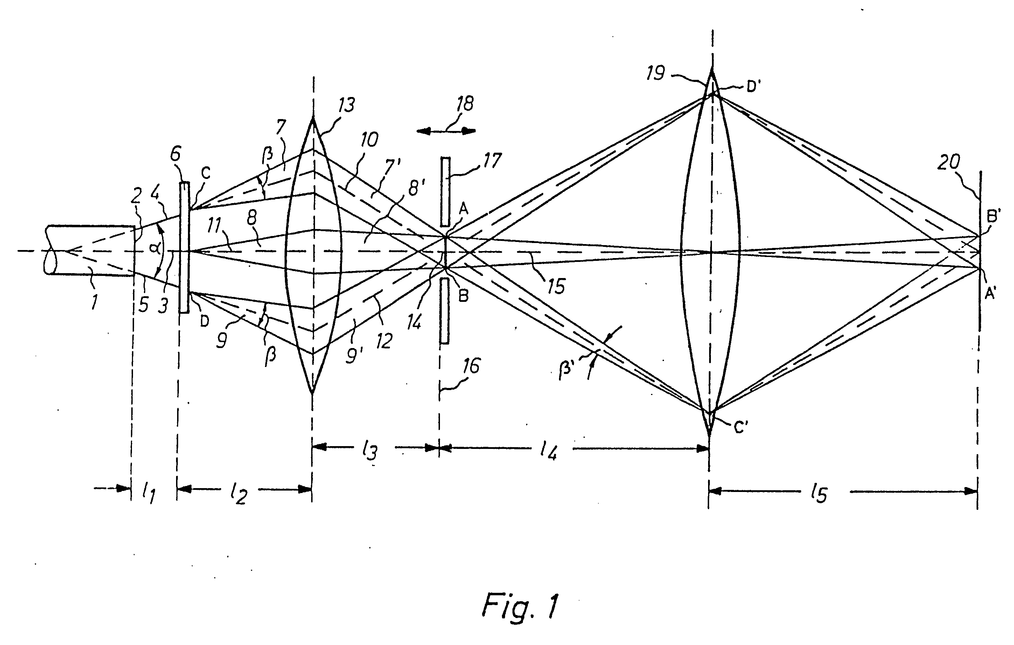

Figur 1 zeigt ein Schnittbild durch ein optisches Aufzeichnungsorgan. Das von einer nicht dargestellten ortsfesten Laser-Lichtquelle ausgehende Licht wird in einen Lichtleiter 1 eingekoppelt. Der Lichtleiter 1 ist vom Multimode-Type und als Stufenindexfaser oder als Gradientenfaser ausgebildet. Der Lichtleiter 1 kann eine Einzelfaser oder ein Faserbündel sein. Derartige Lichtleiter sind dem Fachmann bekannt und z. B. in dem Buch von H.-G. Unger « Optische Nachrichtentechnik », 1976, Elitera-Verlag, Berlin 33 beschrieben.

Aufgrund der sich innerhalb des Lichtleiters 1 aus bildenden Moden ist die Lichtverteilung in der Austrittsfläche 2 des Lichtleiters 1 ungleichförmig. Diese ungleichförmige Lichtverteilung kann man sich so vorstellen, daß die unter verschiedenen Winkeln innerhalb der Austrittsapertur des Lichtleiters 1 austretenden Lichtstrahlen unterschiedliche Intensität und Polarisation aufweisen. Von den Lichtstrahlen sind in Figur 1 nur der Mittelpunktstrahl 3 und die Randstrahlen 4 und 5 dargestellt. Diese ungleichförmige Lichtverteilung würde bei herkömmlichen Aufzeichnungsorganen zu einer unbefriedigenden Blendenausleuchtung führen.

Zur Verbesserung der Blendenausleuchtung ist ein streuendes Medium 6 mit einem Streuwinkel $\beta$, beispielsweise eine Streuscheibe, in einem Abstand $1_1$ von der Austrittsfläche 2 angeordnet. Die Streuscheibe 6 fächert die Moden, dargestellt durch die Strahlen 3, 4 und 5 in Strahlenbündel 7, 8 und 9 auf, die mit dem Streuwinkel $\beta$ divergieren. Die Mittelpunktstrahlen 10, 11 und 12 der Strahlenbündel 7, 8 und 9 werden durch eine erste Linse 13 mit der Brennweite $f_1$ in einem Punkt 14 auf der optischen Achse 15 überlagert.

Die erste Linse 13 hat den Abstand $l_1 + l_2$ von der Austrittsfläche 2 und der Punkt 14 einen Abstand $l_3$ von der ersten Linse 13. Die Randstrahlen der von der ersten Linse 13 ausgehenden und mit dem Winkel β konvergierenden Strahlenbündel 7', 8' und 9' schneiden sich in den Punkten A und B, die in einer durch den Punkt 14 und senkrecht zur optischen Achse 15 verlaufenden Ebene 16 liegen. In dieser Ebene 16 überlagern sich sämtliche Strahlenbündel zu einem Überlagerungsbild AB.

Eine Blende 17 ist in einem Bereich 18, der sich links und rechts der Ebene 16 erstreckt, vorzugsweise aber in dem Ort des Überlagerungsbildes AB in der Ebene 16 angeordnet. Stimmt der Durchmesser des Überlagerungsbildes AB mit der Öffnung der Blende 17 überein, ist der Streuwinkel β optimal an den Aperturwinkel β' der Blende 17 angepaßt, so daß an der Blende 17 kein Lichtverlust auftritt. Jedes von der ersten Linse 13 ausgehende, konvergierende Strahlenbündel 7', 8' und 9' leuchtet für sich allein die Blendenöffnung voll aus, wodurch die unterschiedlichen Intensitäten der Moden bzw. der Strahlenbündel und die Intensitätsschwankungen aufgrund einer mechanischen Bewegung des Lichtleiters 1 in vorteilhafter Weise kompensiert werden. Die Folge ist eine gleichförmige Lichtverteilung innerhalb der Blendenöffnung.

Das Überlagerungsbild AB wird mit Hilfe einer zweiten Linse 19 als Objektiv mit der Brennweite $f_2$ nach der Beziehung :

$$1/f_2 = 1/l_4 + 1/l_5 \qquad (1)$$

auf ein lichtempfindliches Aufzeichnungsmedium 20 als Belichtungsbild A'B' abgebildet. Das Belichtungsbild A'B' hat jetzt ebenfalls eine homogene Lichtverteilung, so daß in vorteilhafter Weise eine streifenfreie Aufzeichnung erfolgt.

Die Größen $l_4$, $l_5$ und $f_2$ bestimmen den Abbildungsmaßstab. Mit Hilfe eines Zoom-Objektivs kann die Größe des Belichtungsbildes (Belichtungspunkt) an die gewünschte Aufzeichnungsfeinheit angepaßt werden.

In einer weiteren Ausgestaltung wird die auf der Streuscheibe 6 aufgefangene Intensitätsverteilung der Moden (Streubild CD) nach der Beziehung :

$$1/f_1 = 1/l_3 + l_4 + 1/l_2 \qquad (2)$$

in die nutzbare Pupille C'D' der zweiten Linse 19 abgebildet, so daß das gesamte von der Öffnung der Blende 17 ausgehende Licht ohne Lichtverlust durch das Objektiv 19 gelangt.

In der Praxis werden häufig optische Anordnungen mit unterschiedlich großen Blendenöffnungen verwendet. Zur Vermeidung von Lichtverlusten müßte der Streuwinkel β der Streuscheibe 6 jeweils dem Aperturwinkel β' der Blende 17 optimal angepaßt werden. In der Anordnung nach Figur 1 kann die Anpassung beispielsweise in engen Grenzen durch Ändern des Abstandes $l_1$ der Streuscheibe 6 von der Austrittsfläche 2 des Lichtleiters 1 oder durch Einschwenken einer Streuscheibe mit einem geänderten Streuwinkel β erfolgen.

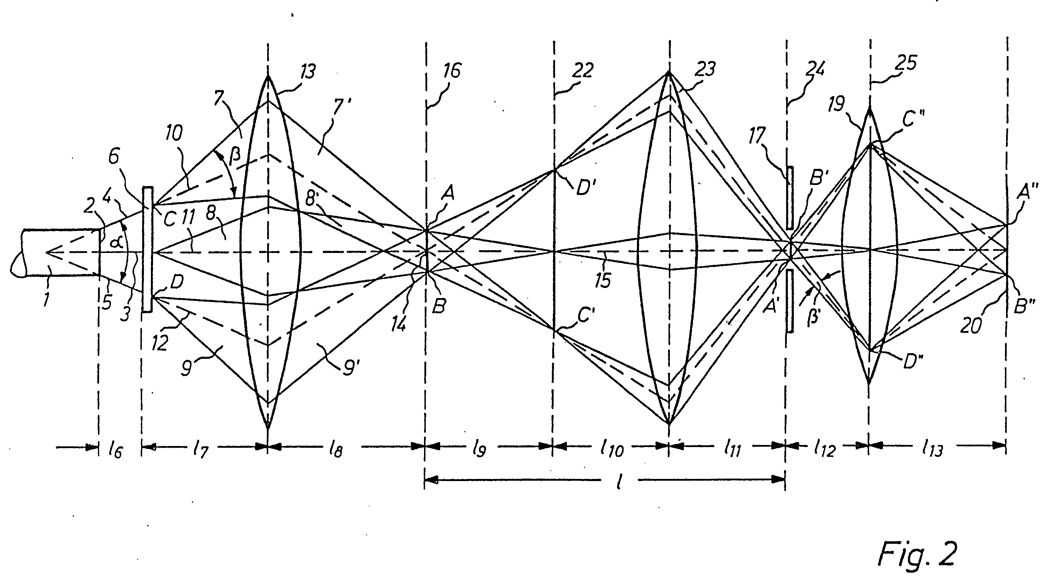

Figur 2 zeigt ein bevorzugtes weiteres Ausführungsbeispiel für ein optisches Aufzeichnungsorgan, bei dem die verschiedenen Parameter, wie Blendenöffnung, Durchmesser und Austrittsapertur des Lichtleiters sowie Normbrennweiten der verwendeten Linsen mit Hilfe von Zwischenabbildungen aneinander angepaßt werden.

Die von der ersten Linse 13 ausgehenden Strahlenbündel 7', 8' und 9' erzeugen wiederum in der Ebene 16 das Überlagerungsbild AB und in einer parallelen Ebene 22 das Bild der Streuscheibe D'C' als Zwischenabbildungen.

Gegenüber Figur 1 ist zwischen erster Linse 13 und zweiter Linse 19 eine dritte Linse 23 mit der Brennweite $f_3$ angeordnet. Die dritte Linse 23 bildet das Überlagerungsbild AB in eine Ebene 24 (B'A') und das Bild der Streuscheibe D'C' in eine Ebene 25 (C''D'') ab. In der Ebene 24 ist die Blende 17 und in der Ebene 25 die zweite Linse 19 als Objektiv angeordnet.

Der Abbildungsmaßstab für das Überlagerungsbild B'A' kann gemäß der Gleichung :

$$1/f_3 = 1/l_9 + 1/l_{10} + 1/l_{11} \qquad (3)$$

durch die Abstände $l_9$, $l_{10}$ und $l_{11}$ sowie durch Einschwenken von Linsen unterschiedlicher Brennweiten geändert werden. Dadurch läßt sich die Größe des Überlagerungsbildes B'A' mit der Blendenöffnung der gerade zu verwendenden Blende 17 in Übereinstimmung bringen, so daß sämtliche Strahlenbündel ohne Lichtverlust durch die Blendenöffnung hindurchtreten und der Streuwinkel β optimal an den jeweiligen Aperturwinkel β' der Blenden angepaßt ist.

Stimmt weiterhin die Größe des Streubildes C''D'' mit der nutzbaren Pupille des Objektivs 19 überein, ist die Intensität des Lichtbündels vor und hinter dem Objektiv gleich groß, was sich mit Vorteil bei einer Regelung des auf das Aufzeichnungsmedium fallenden Lichtes ausnutzen läßt. In diesem Falle kann nämlich die Istwert-Erfassung vor dem Objektiv 19 erfolgen, da der geringe Abstand zwischen Objektiv und Aufzeichnungsmedium oft nicht das Anbringen eines Sensors zuläßt.

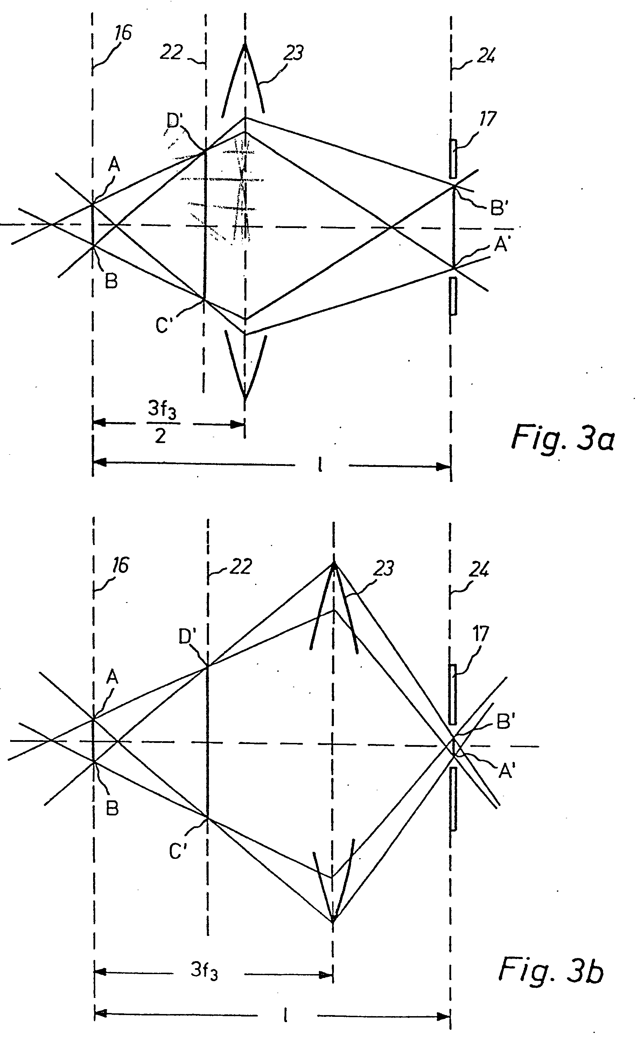

Bei vorgegebenem Abstand $L = l_9 + l_{10} + l_{11}$ zwischen den Ebenen 16 und 24 und vorgegebener Brennweite $f_3$ für die Linse 23 kann durch Verschiebung der Linse 23 in Richtung der optischen Achse 15 ein Abbildungsmaßstab von « 2 » und « 0,5 » eingestellt werden, so daß, wie in den Figuren 3a und 3b gezeigt, zwei Blenden 17 mit entsprechendem Durchmesserverhältnis voll ausgeleuchtet werden können.

In Figur 3a ist die Linse 23 in einem Abstand $3 f_3/2$ von der Ebene 16 angeordnet, und es wird eine gegenüber dem Überlagerungsbild AB um den Faktor « 2 » vergrößerte Öffnung der Blende 17 ausgeleuchtet. In Figur 3b befindet sich die Linse 23 in einem Abstand $3 f_3$ von der Ebene 16, und es wird eine gegenüber dem Überlagerungsbild AB um den Faktor « 0,5 » verkleinerte Blendenöffnung voll ausgeleuchtet.

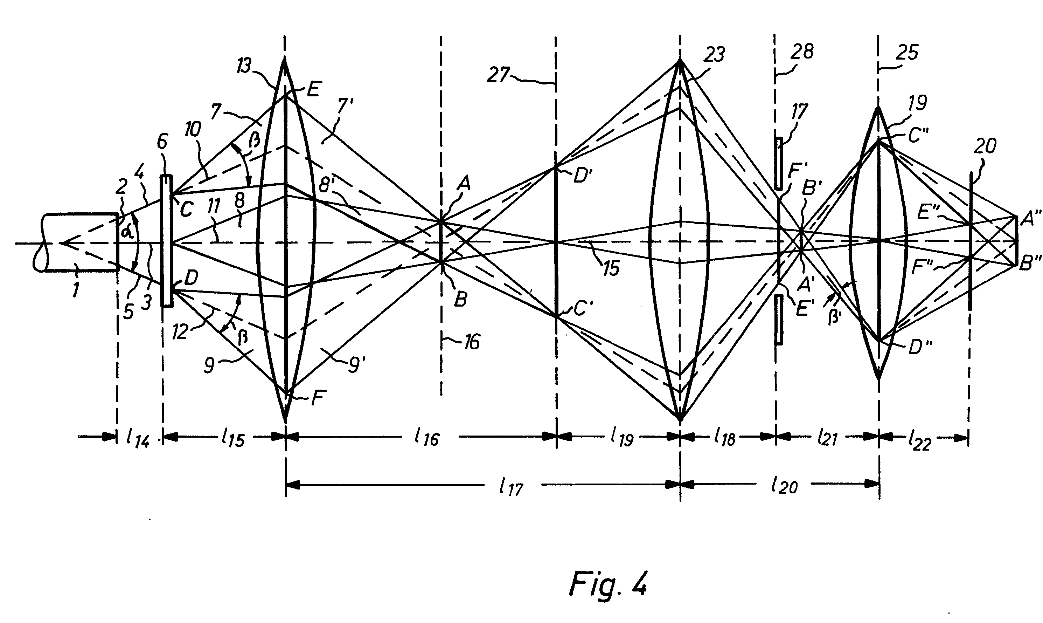

Figur 4 zeigt ein weiteres Ausführungsbeispiel für ein optisches Aufzeichnungsorgan.

Mit Hilfe der ersten Linse 13 (Brennweite $f_1$) wird in einer Ebene 27 ein erstes Zwischenbild D'C' des Bildes CD der Streuscheibe (6) nach der Beziehung :

$$1/f_1 + 1/l_{15} + 1/l_{16} \qquad (4)$$

erzeugt. Die dritte Linse 23 (Brennweite $f_3$) bildet die Pupille EF der Linse 13 in eine Ebene 28 als Zwischenbild F'E' nach der Beziehung :

$$1/f_3 = 1/l_{17} + 1/l_{18} \qquad (5)$$

ab. In der Ebene 28 wird die Blende 17 angeordnet. Der Abbildungsmaßstab für das Pupillenbild EF wird so gewählt, daß das Zwischenbild F'E' wiederum die Öffnung der Blende 17 voll ausleuchtet.

Gleichzeitig bildet die Linse 23 (Brennweite $f_3$) das Zwischenbild C'D' der Streuscheibe 6 in der Pupille der Linse 19 (Objektiv) nach der Gleichung :

$$1/f_3 = 1/l_{19} + 1/l_{20} \qquad (6)$$

ab.

Die Linse 19 bildet nach der Gleichung :

$$1/f_1 = 1/l_{21} + 1/l_{22} \qquad (7)$$

die Öffnung E'F' der Blende 17 als Blendenbild E"F" auf dem Aufzeichnungsmedium 20 ab.

### Gewerbliche Verwertbarkeit

Die Erfindung wird mit Vorteil auf dem gesamten Gebiet der Reproduktionstechnik bei Abtastung und Aufzeichnung mittels einer Lichtübertragung durch Lichtleiter angewendet. Die Erfindung kann aber auch überall dort benutzt werden, wo es bei einer Lichtleiter-Übertragung auf eine homogene Ausleuchtung ankommt.

### Ansprüche

1. Anordnung zur punkt- und zeilenweisen Aufzeichnung von Bildinformationen auf ein lichtempfindliches Aufzeichnungsmedium, insbesondere zur fotomechanischen Herstellung von Druckflächen, mittels eines aus einem Lichtleiter austretenden Strahlenbündels, welches durch eine Blende und ein Objektiv auf dem Aufzeichungsmedium abgebildet wird, dadurch gekennzeichnet, daß zwischen der Austrittsfläche (2) des Lichtleiters (1) und der Blende (17) ein Streumedium (6) zur Aufteilung des Strahlenbündels (3, 4, 5) in Bündel mit dem Streuwinkel (β) divergierender Teilstrahlenbündel (7, 8, 9) und zwischen dem Streumedium (6) und der Blende (17) eine Sammellinse (13) angeordnet ist, daß die Abstände ($l_1$, $l_2$) auf der optischen Achse (15) zwischen Austrittsfläche (2) des Lichtleiters (1) und Streumedium (6) sowie zwischen Streumedium (6) und Sammellinse (13) so bemessen sind, daß die Sammellinse (13) sämtliche Teilstrahlenbündel (7, 8, 9) in einer Ebene (16) mit einem Abstand ($l_3$) zur Sammellinse (13) vollständig überlagert, wobei die Blende (17) im Überlagerungsbereich (18) der Teilstrahlenbündel (7, 8, 9) um die Ebene (16) angeordnet ist und daß die Abstände ($l_4$, $l_5$) zwischen Blende (17), Objektiv (19) und Aufzeichnungsmedium (20) so einstellbar sind, daß die Blendenöffnung durch das Objektiv (19) mit der Brennweite $f_2$ auf das Aufzeichnungsmedium (20) in einem gewünschten Maßstab abgebildet wird.

2. Anordnung nach Anspruch 1, dadurch gekennzeichnet, daß die Abstände ($l_2$, $l_3$, $l_4$) zwischen Streumedium (6), Sammellinse (13) und Objektiv (19) so bemessen sind, daß das Bild (CD) des Streumediums (6) durch die Sammellinse (13) mit der Brennweite $f_1$ in das Objektiv (19) abgebildet wird.

3. Anordnung nach Anspruch 1 oder 2, dadurch gekennzeichnet, daß die Blende (17) in der Ebene (16) angeordnet ist.

4. Anordnung nach Anspruch 1, 2 oder 3, dadurch gekennzeichnet, daß die Größe des Überlagerungsbildes (AB) der Teilstrahlenbündel (7, 8, 9) der Öffnung der Blende (17) entspricht.

5. Anordnung zur punkt- und zeilenweisen Aufzeichnung von Bildinformationen auf ein lichtempfindliches Aufzeichnungsmedium, insbesondere zur fotomechanischen Herstellung von Druckflächen, mittels eines aus einem Lichtleiter austretenden Strahlenbündels, welches durch ein Blende und ein Objektiv auf dem Aufzeichnungsmedium abgebildet wird, dadurch gekennzeichnet, daß zwischen der Austrittsfläche (2) des Lichtleiters (1) und der Blende (17 ein Streumedium (6) zur Aufteilung des Strahlenbündels (3, 4, 5) in Bündel mit dem Streuwinkel (β) divergierender Teilstrahlenbündel (7, 8, 9) und zwischen dem Streumedium (6) und der Blende (17) eine erste Sammellinse (13) und ein zweite Sammellinse (23) angeordnet sind, daß die Abstände ($l_6$, $l_7$) auf der optischen Achse (15) zwischen Austrittsfläche (2) des Lichtleiters (1) und Streumedium (6) sowie zwischen Streumedium (6) und erster Sammellinse (13) so bemessen sind, daß die erste Sammellinse (13) sämtliche Teilstrahlenbündel (7, 8, 9) als erstes Überlagerungsbild (AB) in einer Ebene (16) mit einem Abstand ($l_8$) zur ersten Sammellinse (13) zwischenabbildet, daß die Abstände ($l_9$, $l_{10}$) zwischen der ersten Eben (16) und der zweiten Sammellinse (23) mit der Brennweite $f_3$ so bemessen sind, daß die zweite Sammellinse (23) das erste Überlagerungsbild (AB) als zweites Überlagerungsbild (A'B') mit einem ersten Maßstab in eine zweite Ebene (24) mit einem Abstand ($l_{11}$) zur zweiten Sammellinse (23) abbildet, wobei die Blende (17) in einem Bereich um die zweite Ebene (24) angeordnet ist und daß die Abstände ($l_{12}$, $l_{13}$) zwischen Blende (17), Objektiv (19) und Aufzeichnungsmedium (20) so einstellbar sind, daß die Blendenöffnung durch das Objektiv (19) mit der Brennweite $f_2$ auf das Aufzeichnungsmedium (20) mit einem zweiten Maßstab abgebildet wird.

6. Anordnung nach Anspruch 5, dadurch gekennzeichnet, daß das Bild (CD) des Streumediums (6) durch die erste Sammellinse (13) in eine dritte Ebene (22) zwischenabgebildet wird und daß die Abstände ($I_{10}$, $I_{11}$, $I_{12}$) zwischen dritter Ebene (22), zweiter Sammellinse (23) und Objectiv (19) so bemessen sind, daß das Zwischenbild (C'D) des Streumediums (6) in das Objektiv (19) abgebildet wird.

7. Anordnung nach Anspruch 5 oder 6, dadurch gekennzeichnet, daß die Blende (17) in der zweiten Ebene (24) angeordnet ist.

8. Anordnung nach Anspruch 5 oder 6, dadurch gekennzeichnet, daß die Blende (17) in einer vierten Ebene (28) angeordnet ist, in welcher die Pupille (EF) der ersten Sammellinse (13) durch die zweite Sammellinse (23) als' Bild (E'F') abgebildet wird.

9. Anordnung nach Anspruch 5, 6 oder 7, dadurch gekennzeichnet, daß der erste Maßstab so gewählt ist, daß die Größe des zweiten Überlagerungsbildes (A'B') der Blendenöffnung entspricht.

**Claims**

1. System for dot-by-dot and line-by-line recording of image data on a photosensitive recording medium, in particular for photomechanical production of printing surfaces, by means of a beam emerging from a light conductor which is depicted on the recording medium by means of a light stop and an objective lens, characterised in that a dispersion means (6) for separation of the composite beam (3, 4, 5) into beams of component beams (7, 8, 9) diverging at the dispersion angle ($\beta$) is situated between the egress surface (2) of the light conductor (1) and the light stop (17), and that a condenser lens (13) is situated between the dispersion means (6) and the light stop (17), that the distances ($I_1$, $I_2$) on the optical axis (15) between the egress surface (2) of the light conductor (1) and dispersion means (6) as well as between the dispersion means (6), and the condenser lens (13), are so dimensioned that the condenser lens (13) totally superimposes all the component beams (7, 8, 9) in one plane (16) at a distance ($I_3$) from the condenser lens (13), the light stop or aperture (17) being situated in the area of superimposition (18) of the component beams (7, 8, 9) about the plane (16), and that the distances ($I_4$, $I_5$) between the light stop or aperture (17), lens (19) and recording medium (20) may be adjusted, in such manner that the shutter aperture is depicted to a required scale on the recording medium (20) by means of the lens (19) having the focal length $f_2$.

2. System according to claim 1, characterised in that the distances ($I_2$, $I_3$, $I_4$) between the dispersion means (60), condenser lens (13) and objective lens (19) are so dimensioned that the image (CD) of the dispersion means (6) is depicted on the objective lens (19) by means of the condenser lens (13) having the focal length $f_1$.

3. System according to claim 1 or 2, characterised in that the light stop (17) is situated in the plane (16).

4. System according to claim 1, 2 or 3, characterised in that the size of the superimposition image (AB) of the component beams (7, 8, 9) corresponds to the aperture of the light stop (17).

5. System for dot-by-dot and line-by-line recording of image data on a photosensitive recording medium, in particular of photochemical production of printing surfaces, by means of a beam emerging from a light conductor which is depicted on the recording medium by means of a light stop and an objective lens, characterised in that a dispersion means (6) is situated between the egress surface (2) of the light conductor (1) and the light stop (17) for separation of the composite beam (3, 4, 5) into beams of component beam (7, 8, 9) having the dispersion angle ($\beta$), and that a first condenser lens (13) and a second condenser lens (23) are situated between the dispersion means (6) and the light stop (17), that the distances ($I_6$, $I_7$) on the optical axis (15) between the egress surface (2) of the light conductor (1) and dispersion means (6) as well as between the dispersion means (6) and the first condenser lens (13) are so dimensioned that the first condenser lens (13) produces an intermediate image of all component beams (7, 8, 9) as a first superimposition picture (AB) in a plane (16) at a distance ($I_8$) from the first condenser lens (13), that the distances ($I_9$, $I_{10}$) between the first plane (16) and the second condenser lens (23) having the focal length $f_3$ are so dimensioned that the second condenser lens (23) depicts the first superimposition image (AB) as a second superimposition image (A'B') to a first scale, in a second plane (24), at a distance ($I_{11}$) from the second condenser lens (23), the light stop (17) being situated in an area about the second plane (24), and that the distances ($I_{12}$, $I_{13}$) between the light stop (17), objective lens (19) and recording medium (20) are adjustable, in such manner that the light stop aperture is depicted on the recording medium to a second sale by means of the objective lens (19) having the focal length $f_2$.

6. System according to claim 5, characterised in that the image (CD) of the dispersion means (6) is produced as an intermediate image in a third plane (22) by the first condenser lens (13), and that the distances ($I_{10}$, $I_{11}$, $I_{12}$) between the third plane (22), the second condenser lens (23) and the objective lens (19) are so dimensioned that the intermediate image (C'D) of the dispersion means (6) is depicted in the objective lens (19).

7. System according to claim 5 or 6, characterized in that the light stop (17) is situated in the second plane (24).

8. System according to claim 5 or 6, characterised in that the light stop (17) is situated in a fourth plane (28) in which the aperture (EF) of the first condenser lens (13) is depicted as an image (E'F') by the second condenser lens (23).

9. System according to claim 5, 6 or 7, characterised in that the first scale is so selected that the size of the second superimposition image (A'B') corresponds to the light stop aperture.

## Revendications

1. Installation pour une reproduction par points et par lignes d'informations visuelles sur un support de reproduction sensible à la lumière, notamment pour la réalisation photo-mécanique de surfaces d'impression, au moyen d'un faisceau lumineux issu d'un conducteur optique, dont l'image est formée, par un diaphragme et un objectif, sur le support de reproduction, installation caractérisée en ce que, entre la surface de sortie (2) du conducteur optique (1) et le diaphragme (17), est disposé un organe de dispersion (6), pour le partage du faisceau de rayons (3, 4, 5) en faisceaux partiels (7, 8, 9) divergents avec un angle de dispersion (bêta) et, entre l'organe de dispersion (6) et le diaphragme (17) est disposée une lentille collectrice (13) les distances ($l_1$, $l_2$) sur l'axe optique (15) entre la surface de sortie (2) du conducteur optique (1) et l'organe de dispersion (6) ainsi qu'entre l'organe de dispersion (6) et la lentille collectrice (13), étant choisies de telle sorte que la lentille collectrice (13) transmet la totalité des faisceaux partiels (7, 8, 9) superposés dans un plan (16) à une distance ($l_3$) de la lentille collectrice (13) le diaphragme (17) étant disposé autour du plan (16) dans le domaine de superposition (18) des faisceaux partiels (7, 8, 9), et les distances ($l_4$, $l_5$) entre le diaphragme (17), l'objectif (19) et le support de reproduction (20) sont réglables de telle façon que l'ouverture du diaphragme à son image formée par l'objectif (19) à distance focale $f_2$, sur le support de reproduction (20), à une échelle désirée.

2. Installation suivant la revendication 1, caractérisée en ce que les distances ($l_2$, $l_3$, $l_4$) entre l'organe de dispersion (6), la lentille collectrice (13) et l'objectif (19) sont choisies telles que l'image (CD) de l'organe de dispersion (6) soit formée, par la lentille collective (13) de distance focale $f_1$, dans l'objectif (19).

3. Installation suivant l'une des revendications 1 ou 2, caractérisée en ce que le diaphragme (17) est disposé dans un plan (16).

4. Installation suivant l'une quelconque des revendications 1 à 3, caractérisée en ce que la grandeur de l'image de superposition (AB) des faisceaux partiels (7, 8, 9) correspond à l'ouverture du diaphragme (17).

5. Installation pour la reproduction par points et par lignes d'informations optiques sur un support de reproduction sensible à la lumière, notamment pour la réalisation photo-mécanique de plaques d'impression, au moyen d'un faisceau de rayons sortant d'un conducteur optique dont l'image est formée, par un diaphragme et un objectif, sur la plaque de reproduction, installation caractérisée en ce que, entre la surface de sortie (2) du conducteur optique (1) et le diaphragme (17), est disposé un organe de dispersion (6) pour le partage du faisceau de rayons (3, 4, 5) en faisceaux partiels (7, 8, 9) et, entre cet organe de dispersion (6) et le diaphragme (17), sont disposées une première lentille collectrice (13) et une seconde lentille collectrice (23), les distances ($l_6$, $l_7$) entre la surface de sortie (2) du conducteur optique (1) et l'organe de dispersion (6), ainsi qu'entre l'organe de dispersion (6) et la première lentille collectrice (13), étant prévues telles que la première lentille (13) forme une image de l'ensemble des faisceaux partiels (7, 8, 9), comme une première image superposée (AB), dans un plan (16) situé à une distance ($l_8$) de la première lentille (12) les distances ($l_9$, $l_{10}$), entre ce premier plan (16) et la seconde lentille (23) de distance focale $f_3$, étant choisies telles que la seconde lentille (23) forme une image de la première image superposée (AB) comme seconde image superposée (A'B'), à une première échelle de reproduction, dans un second plan (24) à une distance ($l_{11}$) de la seconde lentille (23), le diaphragme (17) étant disposé dans un domaine autour du second plan (24), les distances ($l_{12}$, $l_{13}$) entre le diaphragme (17), l'objectif (19) et la surface de reproduction (20) étant réglables de telle sorte que l'ouverture du diaphragme ait son image formée, par l'objectif (19) de distance focale $f_2$, sur la surface de reproduction (20) à une seconde échelle de représentation.

6. Installation suivant la revendication 5, caractérisée en ce que l'image (CD) de l'organe de dispersion (6) est formée par la première lentille collectrice (13) comme image intermédiaire dans un troisième plan (22), les distances ($l_{10}$, $l_{11}$, $l_{12}$) entre ce troisième plan (22), la seconde lentille (23) et l'objectif (19) étant choisies telles que l'image intermédiaire (C'D') de l'organe de dispersion (6) soit formée dans l'objectif (19).

7. Installation suivant des revendications 5 ou 6, caractérisée en ce que le diaphragme (17) est disposé dans le second plan (24).

8. Installation suivant l'une des revendications 5 ou 6, caractérisée en ce que le diaphragme (17) est disposé dans un quatrième plan (28) dans lequel l'image de la pupille (EF) de la première lentille (13) est formée par la seconde lentille (23) comme un image (E'F').

9. Installation suivant l'une quelconque des revendications 5, 6 ou 7, caractérisée en ce que la première échelle de reproduction est choisie de telle sorte que la grandeur de la seconde image superposée (A'B') corresponde à l'ouverture du diaphragme.

Fig. 1

Fig. 2

Fig. 3a

Fig. 3b

*Fig. 4*

0 031 155